# EUROPEAN PATENT SPECIFICATION

(11) **EP 3 563 428 B1**
(45) Date of publication and mention of the grant of the patent: **17.02.2021**
(21) Application number: 17830094.3
(22) Date of filing: 28.12.2017
(51) Int. Cl.: H01L 33/00, H01L 33/48, H01L 33/60, H01L 33/62

(54) **METHOD FOR MANUFACTURING LIGHT EMITTING DEVICES USING ELECTROFORM STENCIL PRINTING**
VERFAHREN ZUR HERSTELLUNG LICHTEMITTIERENDER VORRICHTUNGEN MIT VERWENDUNG VON ELEKTROFORM-SCHABLONENDRUCK
PROCÉDÉ DE FABRICATION DE DISPOSITIFS ÉLECTROLUMINESCENTS UTILISANT L'IMPRESSION PAR STENCIL ÉLECTROFORME

(30) Priority: 30.12.2016 US 201662440930 P; 20.03.2017 EP 17161845; 21.12.2017 US 201715851401
(43) Date of publication of application: 06.11.2019
(73) Proprietor: Lumileds LLC, San Jose, CA 95131 (US)
(72) Inventor: VAKKALANKA, Sridevi A., San Jose CA 95131 (US); PEDDADA, S. Rao, San Jose California 95131 (US)
(74) Representative: ter Heegde, Paul Gerard Michel
(86) International application number: PCT/US2017/068678
(87) International publication number: WO 2018/125985

(56) References cited:
- EP-A2- 1 411 557
- DE-A1-102014 102 259
- US-A1- 2003 061 948
- US-A1- 2012 187 862
- US-A1- 2016 300 988
- WILLIAM E COLEMAN: "Two Print Stencils Systems", IPC APEX EXPO CONFERENCE & EXHIBITION 2013, 21 February 2013 (2013-02-21), XP055405755,
- CABAHUG E A ET AL: "Solder Stencil Printing On Deep Cavity", ELECTRONICS PACKAGING TECHNOLOGY CONFERENCE, 2008. EPTC 2008. 10TH, IEEE, PISCATAWAY, NJ, USA, 9 December 2008 (2008-12-09), pages 683-688, XP031413883, ISBN: 978-1-4244-2117-6

## Description

### CROSS REFERENCE TO RELATED APPLICATIONS

This application claims the benefit of U.S. Provisional Patent Application Number 62/440,930 filed on December 30, 2016, European Patent Application Number 17161845.7 filed March 20, 2017, and U.S. Non-Provisional Patent Application Number 15/851,401 filed December 21, 2017.

### FIELD OF INVENTION

The present disclosure relates to a method for manufacturing light emitting diodes (LEDs), in general, and more particularly, to a method for manufacturing an LED package using electroform stencil printing.

### BACKGROUND

Light emitting diodes ("LEDs") are commonly used as light sources in various applications. The main functional part of an LED may be a semiconductor chip comprising two injecting layers of opposite conductivity types (p-type and n-type), and a light-emitting active layer for radiative recombination in which injection of carriers takes place. The semiconductor chip is usually placed in a package that provides electrical connections between the LED chip and the outside world, in addition to protection against vibration, mechanical shock, and overheating. The protection provided by LED packaging against vibration, mechanical shock, and overheating is essential with respect to the reliable operation LED-based light emitting devices.

US 2016/0300988 A1 discloses a light emitting device package, a backlight unit, an illumination apparatus, and a method of manufacturing a light emitting device package capable of being used for a display application or an illumination application. The light emitting device package includes: a flip-chip type light emitting device having a first terminal and a second terminal installed therebeneath; a substrate having a first electrode formed at one side of an electrode separating space and a second electrode formed at the other side thereof; a first conductive bonding member installed on the first electrode of the substrate so as to be electrically connected to the first terminal of the light emitting device; a second conductive bonding member installed on the second electrode of the substrate so as to be electrically connected to the second terminal of the light emitting device; a reflection encapsulant molded and installed on the substrate so as to form a reflection cup part reflecting light generated in the light emitting device and filled in the electrode separating space to form an electrode separating part; and a filler filled between the reflection cup part and the first and second conductive bonding members.

### SUMMARY

The invention is defined in the claims. According to the invention, a method is disclosed for manufacturing light emitting devices, comprising: providing a package body including: (i) a reflector cup defining a cavity, wherein the reflector cup is molded over a metal base including two portions, and (ii) a plurality of metal pads disposed at a bottom surface of the cavity; performing reservoir stencil printing to deposit a respective solder pattern on each of the metal pads, the reservoir stencil printing being performed using a 3D electroform stencil that is placed over the reflector cup, the 3D electroform stencil including a lip configured to engage one or more sidewalls of the reflector cup, and a reservoir extending away from the lip and into the cavity; placing an LED die on the solder patterns that are formed on the metal pads and performing reflow soldering to attach the LED die to the metal pads, wherein the reservoir includes a first plurality of apertures and a second plurality of apertures, the first plurality of apertures being formed at a first location in a bottom surface of the reservoir, and the second plurality of aperture being formed at a second location in the bottom surface of the reservoir, wherein the apertures are used for releasing solder from the reservoir onto the metal pads, wherein each of the first and the second location on the bottom surface of the reservoir corresponds to a metal pad of the metal pads disposed on the bottom interior surface of the reflector cup in being situated directly above the respective metal pad when the 3D electroform stencil is inserted in the reflector cup, wherein each of the portions includes one metal pad and a plurality of protrusions, wherein the plurality of protrusions is arranged on the outer edges of the metal pads and wherein the protrusions are at least partly engulfed by the molding compound used to form the reflector cup.

### BRIEF DESCRIPTION OF THE DRAWINGS

The drawings described below are for illustration purposes only. The drawings are not intended to limit the scope of the present disclosure. Like reference characters shown in the figures designate the same parts in the various embodiments.
FIG. 1A is a top-down perspective view of an example of an LED package body, according to aspects of the disclosure which do not form part of the claimed invention;
FIG. 1B is a top-down perspective view of an example of a metal base that is part of the LED package body of FIG. 1A, according to aspects of the disclosure which do not form part of the claimed invention;
FIG. 2A is a cross-sectional side view of the LED package body of FIG. 1A, according to aspects of the disclosure which do not form part of the claimed invention;
FIG. 2B is a top-down view of the LED package body of FIG. 1A, according to aspects of the disclosure which do not form part of the claimed invention;
FIG. 3A is cross-sectional side view of an example of a 3D electroform stencil, according to aspects of the disclosure which form part of the claimed invention;
FIG. 3B is a top-down view of the 3D electroform stencil of FIG. 3A, according to aspects of the disclosure which form part of the claimed invention;
FIG. 4 is a flowchart of an example of a process for manufacturing light emitting devices, according to aspects of the disclosure which form part of the claimed invention;
FIG. 5 is a diagram illustrating the performance of a step in the process of FIG. 4, according to aspects of the disclosure which form part of the claimed invention;
FIG. 6 is a diagram illustrating the performance of another step in the process of FIG. 4, according to aspects of the disclosure which form part of the claimed invention;
FIG. 7 is a diagram illustrating the performance of yet another step in the process of FIG. 4, according to aspects of the disclosure, which form part of the claimed invention;
FIG. 8 is a diagram illustrating the performance of yet another step in the process of FIG. 4, according to aspects of the disclosure which form part of the claimed invention;
FIG. 9A cross-sectional side view of a light emitting device which does not form part of the claimed invention that is produced as a result of executing the process of FIG. 4, according to aspects of the disclosure; and
FIG. 9B is top-down view of the light-emitting device of FIG. 9A, according to aspects of the disclosure which do not form part of the claimed invention.

### DETAILED DESCRIPTION

According to aspects of the disclosure which do not form part of the claimed invention an improved LED package is disclosed that is suitable for use in automotive lighting applications. The LED package may include an undersized reflector cup and an LED die that is attached to the package's contacts with gold-tin solder. The reflector cup may have an opening that is at most 30% larger than a footprint of the LED die, which may permit the LED package to fit in constrained spaces, such as those found inside automotive headlights. The use of gold-tin solder may further render the LED package suitable for use in automotive applications, as gold-tin solder generally has a high melting point which may prevent it from melting when exposed to the thermal conditions normally present inside automotive headlights.

According to aspects of the disclosure which form part of the claimed invention a method for manufacturing the improved LED package is disclosed in which a 3-dimensional (3D) electroform stencil is used to deposit the gold-tin solder. When the 3D electroform stencil is used, the reservoir of the 3D electroform stencil is inserted inside the reflector cup and filled with solder paste. Afterwards, the solder paste is driven through apertures at the bottom of the 3D electroform stencil to deposit a respective solder pattern onto each of a plurality of metal pads that are exposed on the interior bottom surface of the reflector cup. In some aspects, using the 3D electroform stencil may be necessary when gold-tin solder is used in order to prevent bridging between the solder patterns.

Bridging between two solder patterns may occur when the solder paste used to form one solder pattern flows into the other solder pattern to create a short circuit. The use of the 3D electroform stencil discussed above may ensure that gold-tin solder paste can be deposited in sufficient quantities and with sufficient precision to prevent bridging. Furthermore, the use of the 3D electroform stencil discussed above may be preferable over dispensing gold-tin solder paste directly into the reflector cup of the improved LED package, as the physical properties of the gold-tin solder paste could make it prone to bridging when direct dispensation is used.

According to aspects of the disclosure which do not form part of the claimed invention a light emitting device is disclosed, comprising: a reflector cup coupled to a base to define a cavity, the base including a plurality of metal pads exposed on a bottom surface of the cavity, and the base further including a plurality of protrusions arranged around a perimeter of the base and disposed inside one or more sidewalls of the reflector cup; and an LED die disposed over the bottom surface of the cavity, the LED die being coupled to the metal pads using gold-tin solder, the LED die having a footprint that is at most 30% smaller than an area of a top opening of the cavity.

Examples of LED packages, and methods for manufacturing the same, will be described more fully hereinafter with reference to the accompanying drawings. These examples are not mutually exclusive, and features found in one example can be combined with features found in one or more other examples to achieve additional implementations. Accordingly, it will be understood that the examples shown in the accompanying drawings are provided for illustrative purposes only and they are not intended to limit the disclosure in any way. Like numbers refer to like elements throughout.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein. the term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. It will be understood that these terms are intended to encompass different orientations of the element in addition to any orientation depicted in the figures.

Relative terms such as "below" or "above" or "upper" or "lower" or "horizontal" or "vertical" may be used herein to describe a relationship of one element, layer or region to another element, layer or region as illustrated in the figures. It will be understood that these terms are intended to encompass different orientations of the device in addition to the orientation depicted in the figures.

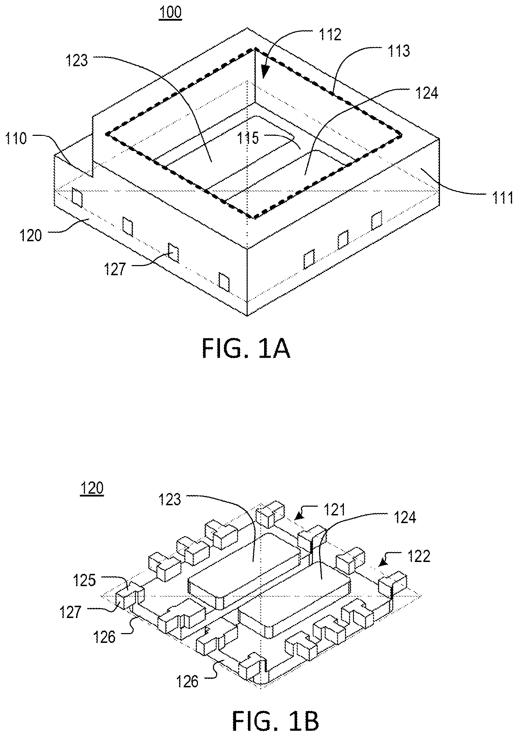

FIG 1A is a perspective view of an example of a light emitting diode (LED) package body 100, according to aspects of the disclosure. The LED package body 100 may include a reflector cup 110 that is molded over a metal base 120, as shown. In some implementations, the reflector cup 110 may be formed of an epoxy molding compound (EMC). Additionally or alternatively, in some implementations, the reflector cup 110 may be formed of a reflective silicone molding compound (SMC), as SMC is capable of withstanding higher processing temperatures and is more reflective than EMC. Although in the present example the reflector cup 110 is formed of either SMC or EMC, alternative implementations are possible in which another material is used. The present disclosure is thus not limited to any specific material for forming the reflector cup 110.

As illustrated in FIG. 1A, the reflector cup 110 may include one or more sidewalls 111 that are arranged to define a cavity 112. The cavity 112 may have a top opening 113 (denoted by a dashed rectangle) and a bottom surface defined at least in part by the base 120. Furthermore, the reflector cup 110 may include a bridge member 115 that extends across the bottom of the cavity 112. In some implementations, the bridge member 115 may be formed of a dielectric material and disposed between metal pads 123 and 124 of the base 120 to electrically insulate the metal pads 123 and 124 from one another. Each of the metal pads 123 and 124 may be at least partially exposed on the interior bottom surface of the cavity 112 of the reflector cup 110 so that electrical connections can be formed between the metal pads 123 and 124 and the electrodes of an LED die that is subsequently inserted into the reflector cup 110.

FIG. 1B is perspective top-down view of the base 120, according to aspects of the disclosure. As illustrated, the base 120 may include a portion 121 and a portion 122. Portion 121 may include the metal pad 123 and a plurality of protrusions 125 that are arranged on the outer edges 126 of the metal pad 123. Portion 122 may include the metal pad 124 and another plurality of protrusions 125 that are arranged on the outer edges 126 of the metal pad 124. In some implementations, the protrusions 125 may overhang the outer edges 126, as shown. When the reflector cup 110 is molded over the base 120, the protrusions 125 may be engulfed by the molding compound used to make the reflector cup 110, thereby ensuring a strong grip of the molding compound over the base 120. Moreover, as illustrated in FIG. 1A, the outer surfaces 127 of the protrusions 125 may be exposed on the sidewalls 111 of the reflector cup 110.

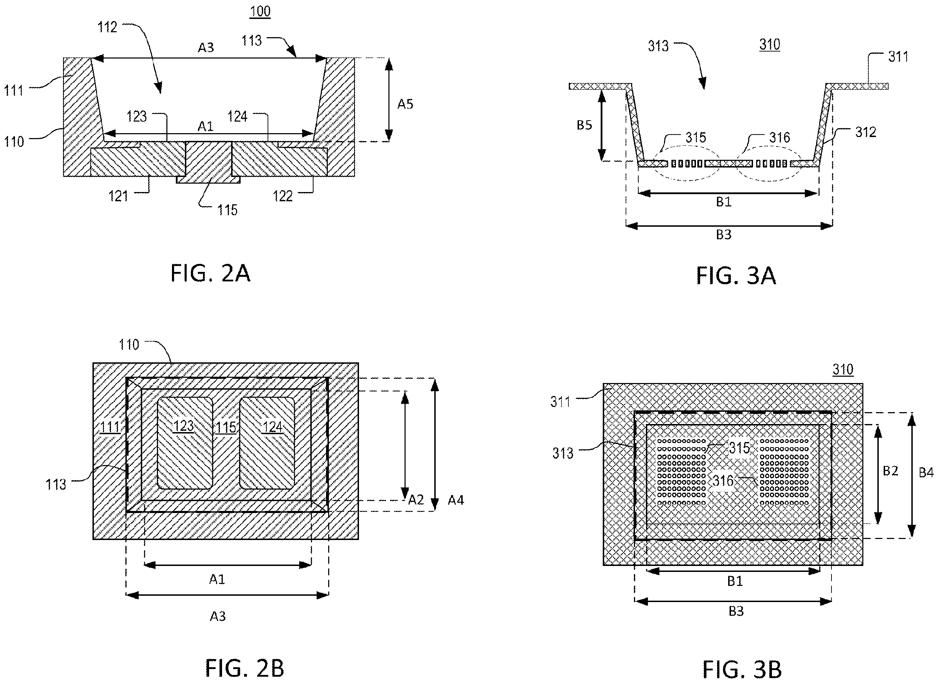

FIG. 2A is a cross-sectional side view of the LED package body 100 and FIG. 2B is a top-down view of the LED package body 100, according to aspects of the disclosure. As illustrated in FIGS. 2A-B, the cavity 112 of the reflector cup 110 may have a trapezoidal cross-section. The bottom surface of the cavity 112 may have a width A1 and length A2 and the top opening 113 of the cavity 112 may have a width A3 and length A4. Moreover, in some implementations, the cavity 112 may have a depth A5 of 4 mm or less.

In the present example, the cavity 112 of the reflector cup 110 has a trapezoidal cross-section. However, alternative implementations are possible in which the cavity 112 has a rectangular cross-section. Although in the present example the width A1 of the bottom surface of the cavity 112 is smaller than the width A3 of the top opening 113 of the cavity 112, alternative implementations are possible in which the width A1 of the bottom surface of the cavity 112 is greater than or equal to the width A3 of top the top opening 113 of the cavity 112. Furthermore, although in the present example, the length A2 of the bottom surface of the cavity 112 is smaller than the length A4 of the top opening 113 of the cavity 112, alternative implementations are possible in which the length A2 of the bottom surface of the cavity 112 is greater than or equal to the length A4 of the top opening 113 of the cavity 112. Stated succinctly, the present disclosure is not limited to any particular set of dimensions and/or shape for the cavity 112 of the reflector cup 110.

FIG. 3A is cross-sectional side view of a 3D electroform stencil 310 that is used to print solder patterns on the metal pads 123 and 124. The 3D electroform stencil 310 includes a lip 311 and a reservoir 312. The reservoir 312 includes a first plurality of apertures 315 and a second plurality of apertures 316 formed on the bottom surface of the reservoir 312. As further discussed below, the apertures 315 and 316 are used for releasing solder from the reservoir 312 onto the metal pads 123 and 124. In this regard, the apertures 315 are formed in a first location on the bottom surface of the reservoir 312 that corresponds to the metal pad 123. Similarly, the apertures 316 are formed in a second location on the bottom surface of the reservoir 312 that corresponds to the metal pad 124. According to aspects of the disclosure which form part of the claimed invention a location on the bottom surface of the reservoir 312 corresponds to a metal pad disposed on the bottom interior surface of the reflector cup 110 only if that location is situated directly above the metal pad when the 3D electroform stencil 310 is inserted in the reflector cup 110.

The 3D electroform stencil 310 may be formed of nickel and/or any other suitable material that permits additive solder paste deposition with smooth sidewalls, sufficient stencil resolution, and sufficient solder paste release. In some implementations, the reservoir 312 of the 3D electroform stencil 310 may be grown from a mandrel that has been machined to match the shape of the cavity 112 of the reflector cup 110. As a result, the reservoir 312 may have a shape that matches the shape of the cavity 112. According to aspects of the disclosure, the shape of the reservoir 312 is said to match the shape of cavity 112 when the shape of the reservoir 312 permits the reservoir 312 to be inserted in the cavity 112 in a way that causes the first plurality of apertures 315 to be disposed directly above the metal pad 123, while the second plurality of apertures 316 is disposed directly above the metal pad 124. Additionally or alternatively, although not shown in FIGS. 3A-B, in some implementations, the bottom surface of the reservoir 312 may have a relief that matches the shape of the bottom surface of the reflector cup 110.

Although FIG. 3A depicts the reservoir 312 as having a trapezoidal cross-section, it will be understood that the reservoir 312 can have any suitable shape. As illustrated in FIGS. 3A-B, the bottom surface of the reservoir 312 may have a width B1 and length B2. Furthermore, the top opening 313 of the reservoir 312 (denoted by a dashed rectangle) may have a width B3 and length B4. In the present example, the width B3 of the top opening 313 of the reservoir 312 is larger than the width B1 of the bottom surface of the reservoir 312. However, alternative implementations are possible in which the width B1 of the bottom surface of the reservoir 312 is greater than or equal to the width B3 of the top opening 313 of the reservoir 312. Furthermore, in the present example, the length B4 of the top opening 313 of the reservoir 312 is larger than the length B2 of the bottom surface of the reservoir 312. However, alternative implementations are possible in which the length B2 of the bottom surface of the reservoir 312 is greater than or equal to the length B4 of the top opening 313 of the reservoir 312. Stated succinctly, the present disclosure is not limited to any set of dimensions and/or shape for the reservoir 312 of the 3D electroform stencil 310.

Although in the example of FIGS. 2A-B and 3A-B, the reservoir 312 of the 3D electroform stencil 310 has a shape that is conformal to the shape of the cavity 112 of the reflector cup 110, this depiction is provided for illustrative of purposes only. As can be readily appreciated, alternative implementations are possible in which the reservoir 312 has a shape that is not conformal to the shape of the cavity 112. For example, alternative implementations are possible in which the cavity 112 still has a trapezoidal cross-section while the reservoir 312 has a U-shaped cross-section.

According to the example of FIGS. 2A-B and 3A-B, the depth A5 of the cavity 112 of the reflector cup 110 is equal to the depth B5 of the reservoir 312 of the 3D electroform stencil 310. However, alternative implementations are possible in which the depth B5 of the reservoir 312 is less than the depth A5 of the cavity 112. In such instances, when the reservoir 312 is inserted into the cavity 112, the bottom surface of the reservoir 312 may sit above the bottom surface of the cavity 112, without making direct contact with the bottom surface of the cavity 112. Moreover, in some implementations, the length B5 of the reservoir 312 may be slightly larger than the length A5 of the cavity 112. Stated succinctly, the present disclosure is not limited to any specific relationship between the depth A5 of the cavity 112 of the reflector cup 110 and the depth B5 of the reservoir 312 of the 3D electroform stencil 310.

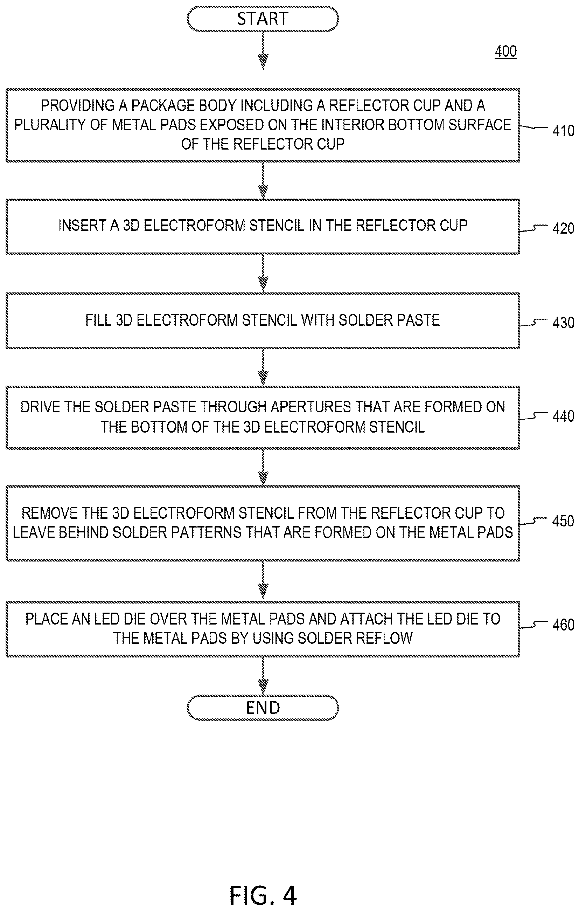

FIG. 4 is a flowchart of an example of a process 400 for manufacturing a light-emitting device by using the LED package body 100 and the 3D electroform stencil 310, according to aspects of the disclosure which form part of the claimed invention.

At step 410, the LED package body 100 is formed by molding the reflector cup 110 over the base 120. As noted above, when the reflector cup 110 is molded over the base 120, the protrusions 125 become at least partially engulfed by the molding compound used to form the reflector cup 110, thereby strengthening the connection between the reflector cup 110 and the base 120. Furthermore, when the reflector cup 110 is molded over the base 120, the bridge member 115 may be formed between metal pads 123 and 124. As noted above, the bridge member 115 may help to electrically isolate the metal pads 123 and 124 from one another.

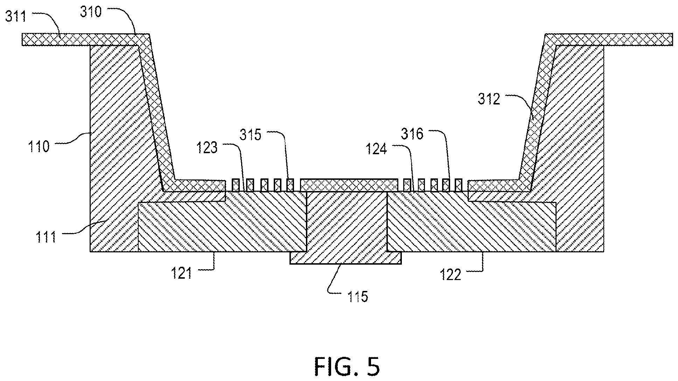

At step 420, the 3D electroform stencil 310 is inserted in the cavity 112 of the reflector cup 110. When the 3D electroform stencil 310 is inserted in the cavity 112 of the reflector cup 110, the reservoir 312 of the 3D electroform stencil 310 is positioned inside the cavity 112 of the reflector cup 110, while the lips 311 of the 3D electroform stencil 310 engage the top surfaces of the sidewalls 111 of the reflector cup 110. FIG. 5 is a diagram showing the LED package body 100 with the 3D electroform stencil 310 inserted in the cavity 112 of the reflector cup 110. In this example, when the 3D electroform stencil 310 is inserted into cavity 112, the bottom surface of the reservoir 312 comes in contact with the bottom surface of the cavity 112. However, alternative implementations are possible in which the bottom surface of the reservoir 312 does not come in contact with the bottom surface of the cavity 112. In such instances, the bottom surface of the reservoir 312 may be suspended above the bottom surface of the cavity 112.

Furthermore, although in the present example, the shape of the reservoir 312 of the 3D electroform stencil 310 is conformal to the shape of the cavity 112 of the reflector cup 110, alternative implementations are possible in which the shape of the reservoir 312 of the 3D electroform stencil 310 is non-conformal to the shape of the cavity 112 of the reflector cup 110. For example, in some implementations, the reservoir 312 may have a U-shaped cross-section. In such instances, when the 3D electroform stencil 310 is inserted in the reflector cup 110, a bottom portion of the sidewalls of the reservoir 312 may come in contact with the sidewalls of the cavity 112, while a top portion of the sidewalls of the reservoir 312 remains separated from the sidewalls of the cavity 112.

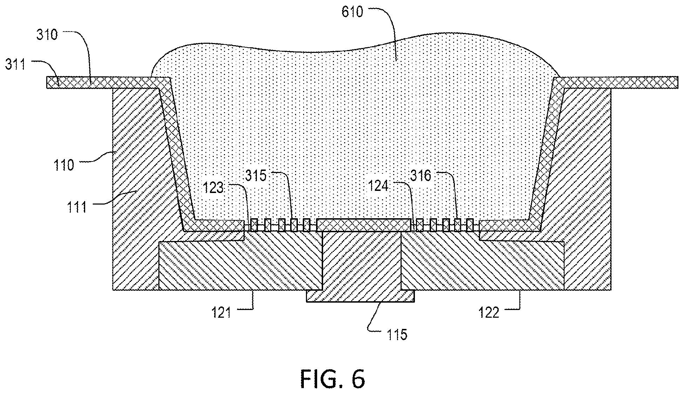

At step 430, the reservoir 312 of the 3D electroform stencil 310 is filled with solder paste. FIG. 6 is a diagram showing the 3D electroform stencil 310 after it is filled with solder paste 610. Although in the preset example, at step 430, the reservoir 312 of the 3D electroform stencil 310 is completely filled with solder paste 610, alternative implementations are possible in which the reservoir 312 of the 3D electroform stencil 310 is only partially filled with the solder paste 610. In some implementations, the solder paste 610 may include a gold-tin solder paste because of its high melting point, non-creep, high-tensile stress, thermal and electrical conductivity. However, alternative implementations are possible in which any other suitable type of solder paste is used instead.

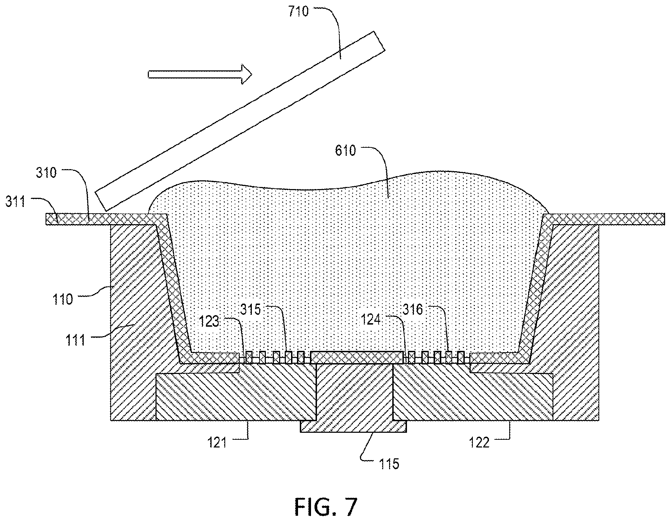

At step 440, at least some of the solder paste 610 in the reservoir 312 of the 3D electroform stencil 310 is driven through the apertures 315 and 316 that are present on the bottom of the reservoir 312. As illustrated in FIG. 7, at least some of the solder paste 610 may be driven through the apertures 315 and 316 by applying a pressure on the solder paste 610 with a squeegee 710. Although in the present example a squeegee is used to drive at least some of the solder paste 610 through the apertures 315 and 316 of the reservoir 312, alternative implementations are possible in which another technique is used instead. Stated succinctly, the present disclosure is not limited to any particular technique for driving the solder paste 610 through the apertures 315 and 316 of the reservoir 312.

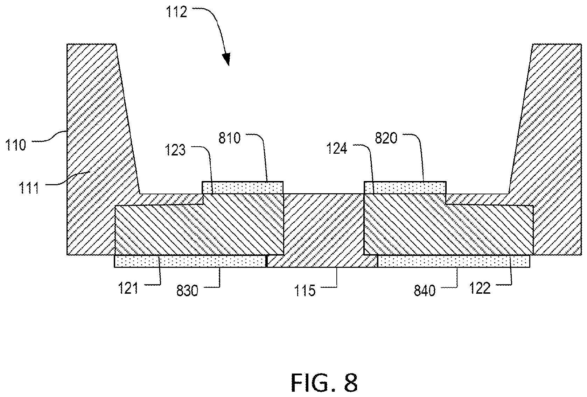

At step 450, the 3D electroform stencil 310 is removed from the LED package body 100. As illustrated in FIG. 8, when the 3D electroform stencil 310 is removed, solder patterns 810 and 820 are left behind on the metal pads 123 and 124. More particularly, the solder pattern 810 is formed on the metal pad 123 and the solder pattern 820 is formed on the metal pad 124, as shown. Each of the solder patterns 810 and 820 may include an array of dots or other shapes. Additionally, in some implementations which do not form part of the claimed invention solder layers 830 and 840 may be disposed on the bottom surfaces of portions 121 and 122 of the base 120. Because the base 120 is formed of metal, the solder layer 830 may be electrically connected to the metal pad 123, and the solder layer 840 may be electrically connected to the metal pad 124. As can be readily appreciated, the solder layers 830 and 840 may be used to connect an LED die that will be disposed in the package body 100 to various electronic circuits.

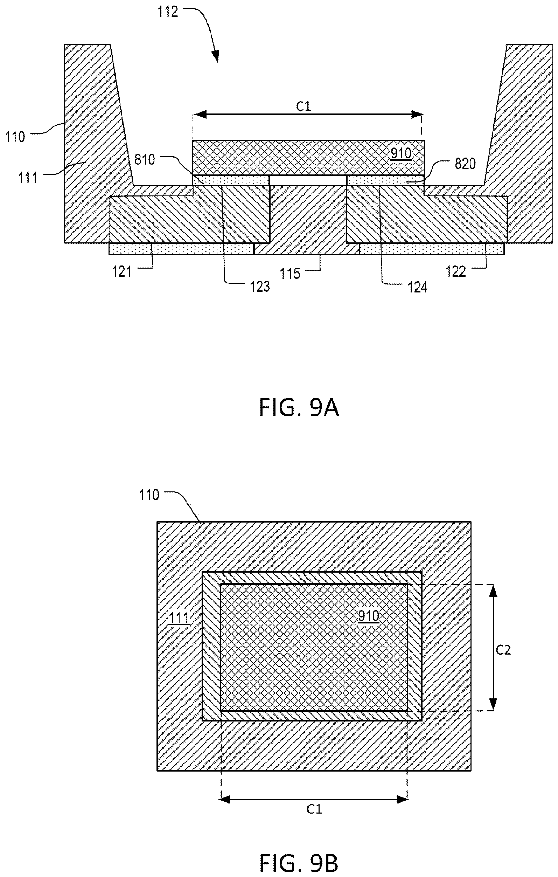

At step 460, an LED die is positioned over the solder patterns 810 and 820 and attached to the metal pads 123 and 124 by using solder reflow. More particularly, as illustrated in FIGS. 9A-B, an LED die 910 may be positioned over the metal pads 123 and 124, such that each of the contact pads of the LED die 910 (not shown) rests over a different one of the solder patterns 810 and 820. In some implementations, the LED die includes an active light-emitting layer that is sandwiched between a first conductivity layer and a second conductivity layer. The first conductivity layer and the second conductivity layer are coupled to different contact pads of the LED die. Furthermore, the first conductivity layer, the second conductivity layer, and the active layer may be formed of any suitable material, such as a GaAs material or a GaN material, for example. In the present example, the LED die 910 is arranged in a flip-chip configuration. However, alternative implementations are possible in which the LED die 910 is arranged in another configuration. Stated succinctly, the present disclosure is not limited to any specific type of LED die being mounted inside the cavity 112 of the reflector cup 110.

As illustrated in FIGS. 9A-B, the LED die 910 may have a width C1 and length C2. The area of the bottom (or top) surface of the LED die 910 may be referred to as footprint of the LED die 910 and it may equal to the product of the width C1 and the length C2. In some implementations, the area of the top opening 113 of the cavity 112 may be larger than the footprint of the LED die 910 by 30% or less. For example, the area of the top opening 113 of the cavity 112 may be larger than the footprint of the LED die 910 by: 20% or less, 10% or less, or 5% or less. In comparison, a cavity's opening in a conventional reflector cup is about 80% larger than the footprint of the LED die that is installed in the conventional reflector cup.

FIGS. 1A-9B are provided as an example only. Although in the above examples, the 3D electroform stencil 310 includes only one reservoir, those of ordinary skill in the art would readily appreciate that alternative implementations are possible in which the 3D electroform stencil 310 includes a plurality of reservoirs that are spaced apart from one another. In such instances, the 3D electroform stencil 310 may be used to print solder patterns in multiple LED package bodies at the same time. More particularly, the 3D electroform stencil 310 may be placed over a plurality of integral package bodies, such that each reservoir is inserted in a different one of the package bodies. Next, solder paste may be disposed in each reservoir and used to form solder patterns in each of the package bodies. Next, a respective LED die may be mounted in each package body by using the solder patterns that are printed using the 3D electroform stencil 310. And finally, after a respective LED die is mounted in each package body, the package bodies may be separated from each other by using a saw and/or any other suitable cutting device.

Although some of the concepts disclosed herein are presented in the context of automotive lighting, it will be understood that the above-described LED package can be employed in any context. For example, the LED package can be used in indoor lighting systems, street lighting systems, stage lighting systems, decorative lighting systems, and greenhouse lighting systems. It will be understood that the provision of the examples described herein, as well as clauses phrased as "such as," "e.g.", "including", "in some aspects," "in some implementations," and the like should not be interpreted as limiting the disclosed subject matter to the specific examples.

Having described the invention in detail, those skilled in the art will appreciate that, given the present disclosure, modifications may be made to the invention without departing from the scope of the invention as defined in the appended claims. Therefore, it is not intended that the scope of the invention be limited to the specific embodiments illustrated and described.

## Claims

1. A method for manufacturing light emitting devices, comprising:
providing a package body (100) including: (i) a reflector cup (110) defining a cavity (112), wherein the reflector cup (110) is molded over a metal base (120) including two portions (121, 122), and (ii) a plurality of metal pads (123, 124) disposed at a bottom interior surface of the cavity (112);
performing reservoir stencil printing to deposit a respective solder pattern (810, 820) on each of the metal pads (123, 124); and placing an LED die on the solder patterns (810, 820) that are formed on the metal pads (123, 124) and performing reflow soldering to attach the LED die to the metal pads (123, 124);
**characterized in that**:
the reservoir stencil printing being performed using a 3D electroform stencil (310) that is placed over the reflector cup (110), the 3D electroform stencil (310) including a lip (311) configured to engage one or more sidewalls of the reflector cup (110), and a reservoir (312) extending away from the lip (311) and into the cavity (112),
wherein the reservoir (312) includes a first plurality of apertures (315) and a second plurality of apertures (316), the first plurality of apertures (315) being formed at a first location in a bottom surface of the reservoir (312), and the second plurality of apertures (316) being formed at a second location in the bottom surface of the reservoir (312), wherein the apertures (315, 316) are used for releasing solder from the reservoir (312) onto the metal pads (123, 124),
whereby each of the first and the second location on the bottom surface of the reservoir (312) corresponds to a metal pad of the metal pads (123, 124) disposed on the bottom interior surface of the reflector cup (110) in being situated directly above the respective metal pad (123, 124) when the 3D electroform stencil (310) is inserted in the reflector cup (110),
wherein each of the portions (121, 122) includes a metal pad (123, 124) and a plurality of protrusions (125), wherein the plurality of protrusions (125) are arranged on the outer edges (126) of the metal pads (123, 124) and wherein the protrusions (125) are at least partly engulfed by the molding compound used to form the reflector cup (110).

2. The method of claim 1, wherein the reflector cup (110) comprises a reflective silicone molding compound (SMC).

3. The method of claim 1, wherein the cavity (112) has a depth of 4 mm or less

4. The method of claim 1, wherein the cavity (112) includes a top opening (113). the top opening (113) being larger than a footprint of the LED die by 30% or less.

5. The method of claim 1, wherein performing the reservoir stencil printing comprises:
placing the reservoir (312) of the 3D electroform stencil (310) into the cavity (112);
filling the reservoir (312) of the 3D electroform stencil (310) with solder paste; and
pushing the solder paste out through one or more apertures that are formed on a bottom surface of the reservoir (312).

6. The method of claim 5, wherein the solder paste includes gold.

7. The method of claim 1, further comprising forming the 3D electroform stencil (310) by using a mandrel that matches a shape of the cavity (112).

8. The method of claim 1, wherein top surfaces of the metal pads (123, 124) are positioned in a central portion of the bottom surface of the cavity (112).

9. The method of claim 1, wherein the 3D electroform stencil (310) is formed at least in part of nickel.

## Patentansprüche

1. Verfahren zum Herstellen lichtemittierender Vorrichtungen, Folgendes umfassend:
Bereitstellen eines Gehäusekörpers (100), der Folgendes beinhaltet: (i) eine Reflektorschale (110), die einen Hohlraum (112) definiert, wobei die Reflektorschale (110) über einer Metallbasis (120) formgegossen ist, die zwei Abschnitte (121, 122) beinhaltet, und (ii) mehrere Metallpads (123, 124), die an einer Bodeninnenfläche des Hohlraums (112) angeordnet sind,
Durchführen eines Reservoir-Schablonendrucks, um auf jedem der Metallpads (123, 124) eine entsprechende Lotstruktur (810, 820) abzuscheiden, und
Platzieren eines LED-Nacktchips auf den Lotstrukturen (810, 820), die auf den Metallpads (123, 124) gebildet sind und Durchführen eines Reflow-Lötens, um den LED-Nacktchip an den Metallpads (123, 124) anzubringen,
**dadurch gekennzeichnet, dass**:
der Reservoir-Schablonendruck mit Hilfe einer 3D-Galvanoschablone (310) durchgeführt wird, die über der Reflektorschale (110) angeordnet wird, wobei die 3D-Galvanoschablone (310) eine Lippe (311) beinhaltet, die dafür gestaltet ist, mit einer oder mehreren Seitenwänden der Reflektorschale (110) in Eingriff zu stehen, und ein Reservoir (312), das sich von der Lippe (311) weg und in den Hohlraum (112) erstreckt,
wobei das Reservoir (312) erste mehrere Öffnungen (315) und zweite mehrere Öffnungen (316) beinhaltet, wobei die ersten mehreren Öffnungen (315) an einer ersten Stelle in einer Bodenfläche des Reservoirs (312) gebildet sind und die zweiten mehreren Öffnungen (316) an einer zweiten Stelle in der Bodenfläche des Reservoirs (312) gebildet sind, wobei die Öffnungen (315, 316) verwendet werden, um Lot von dem Reservoir (312) auf die Metallpads (123, 124) abzugeben,
wobei die erste und die zweite Stelle auf der Bodenfläche des Reservoirs (312) jeweils einem Metallpad der Metallpads (123, 124) entsprechen, die auf der Bodeninnenfläche der Reflektorschale (110) angeordnet sind, indem sie sich direkt über dem entsprechenden Metallpad (123, 124) befinden, wenn die 3D-Galvanoschablone (310) in die Reflektorschale (110) eingesetzt wird,
wobei jeder der Abschnitte (121, 122) ein Metallpad (123, 124) und mehrere Vorsprünge (125) beinhaltet, wobei die mehreren Vorsprünge (125) auf den Außenkanten (126) der Metallpads (123, 124) angeordnet sind und wobei die Vorsprünge (125) zumindest teilweise von der Formgusszusammensetzung umhüllt werden, die verwendet wird, um die Reflektorschale (110) zu bilden.

2. Verfahren nach Anspruch 1, wobei die Reflektorschale (110) eine reflektierende Silikon-Formgusszusammensetzung (Silicone Molding Compound - SMC) umfasst.

3. Verfahren nach Anspruch 1, wobei der Hohlraum (112) eine Tiefe von 4 mm oder weniger aufweist.

4. Verfahren nach Anspruch 1, wobei der Hohlraum (112) eine obere Öffnung (113) beinhaltet, wobei die obere Öffnung (113) um 30% oder weniger größer als eine Grundfläche des LED-Nacktchips ist.

5. Verfahren nach Anspruch 1, wobei das Durchführen des Reservoir-Schablonendrucks Folgendes umfasst:
Platzieren des Reservoirs (312) der 3D-Galvanoschablone (310) in dem Hohlraum (112),
Füllen des Reservoirs (312) der 3D-Galvanoschablone (310) mit Lotpaste und
Herauspressen der Lotpaste durch eine oder mehrere Öffnungen, die in einer Bodenfläche des Reservoirs (312) gebildet sind.

6. Verfahren nach Anspruch 5, wobei die Lotpaste Gold beinhaltet.

7. Verfahren nach Anspruch 1, ferner das Bilden einer 3D-Galvanoschablone (310) durch Verwenden eines Dorns, der mit einer Form des Hohlraums (112) übereinstimmt, umfassend.

8. Verfahren nach Anspruch 1, wobei Oberseiten der Metallpads (123, 124) in einem mittleren Abschnitt der Bodenfläche des Hohlraums (112) positioniert werden.

9. Verfahren nach Anspruch 1, wobei die 3D-Galvanoschablone (310) zumindest teilweise aus Nickel gebildet wird.

## Revendications

1. Procédé de fabrication de dispositifs électroluminescents, qui comprend :
le fait de prévoir un corps de boîtier (100) qui comprend : (i) une coupelle réflectrice (110) qui définit une cavité (112), dans lequel la coupelle réflectrice (110) est moulée par-dessus une base métallique (120) qui comprend deux parties (121, 122), et (ii) une pluralité de plots métalliques (123, 124) disposés au niveau d'une surface interne inférieure de la cavité (112) ;
l'exécution d'une impression au pochoir sur un réservoir afin de déposer un motif de soudure respectif (810, 820) sur chacun des plots métalliques (123, 124) ; et
le placement d'une matrice de LED sur les motifs de soudage (810, 820) qui sont formés sur les plots métalliques (123, 124) et l'exécution d'une soudure par refusion afin de joindre la matrice de LED aux plots métalliques (123, 124) ;
**caractérisé en ce que** :
l'impression au pochoir sur un réservoir est effectuée à l'aide d'un pochoir d'électroformage en 3D (310) qui est placé par-dessus la coupelle réflectrice (110), le pochoir d'électroformage en 3D (310) comprenant un rebord (311) configuré pour engager une ou plusieurs paroi(s) latérale(s) de la coupelle réflectrice (110), et un réservoir (312) qui s'étend depuis le rebord (311) et dans la cavité (112),
dans lequel le réservoir (312) comprend une première pluralité d'ouvertures (315) et une seconde pluralité d'ouvertures (316), la première pluralité d'ouvertures (315) étant formée à un premier emplacement sur une surface inférieure du réservoir (312), et la seconde pluralité d'ouvertures (316) étant formée à un second emplacement sur la surface inférieure du réservoir (312), dans lequel les ouvertures (315, 316) sont utilisées pour évacuer la brasure du réservoir (312), vers les plots métalliques (123, 124),
moyennant quoi chacun du premier et du second emplacements sur la surface inférieure du réservoir (312) correspond à un plot métallique des plots métalliques (123, 124) disposés sur la surface interne inférieure de la coupelle réflectrice (110) située directement au-dessus du plot métallique respectif (123, 124) lorsque le pochoir d'électroformage en 3D (310) est inséré dans la coupelle réflectrice (110),
dans lequel chacune des parties (121, 122) comprend un plot métallique (123, 124) et une pluralité de saillies (125), dans lequel la pluralité de saillies (125) est disposée sur les bords externes (126) des plots métalliques (123, 124), et dans lequel les saillies (125) sont au moins partiellement enveloppées par le composé de moulage utilisé pour former la coupelle réflectrice (110).

2. Procédé selon la revendication 1, dans lequel la coupelle réflectrice (110) comprend un composé de moulage en silicone réfléchissant (SMC).

3. Procédé selon la revendication 1, dans lequel la cavité (112) possède une profondeur de 4 mm ou moins.

4. Procédé selon la revendication 1, dans lequel la cavité (112) comprend une ouverture supérieure (113), l'ouverture supérieure (113) étant plus grande qu'une empreinte de la matrice de LED, de 30% ou moins.

5. Procédé selon la revendication 1, dans lequel l'exécution de l'impression au pochoir sur un réservoir comprend :
le placement du réservoir (312) du pochoir d'électroformage en 3D (310) dans la cavité (112) ;
le remplissage du réservoir (312) du pochoir d'électroformage en 3D (310) avec de la pâte de brasure ; et
le fait de pousser la pâte de brasure afin de la faire sortir par une ou plusieurs ouverture(s) formée(s) sur une surface inférieure du réservoir (312).

6. Procédé selon la revendication 5, dans lequel la pâte de brasure comprend de l'or.

7. Procédé selon la revendication 1, comprenant en outre la formation du pochoir d'électroformage en 3D (310) à l'aide d'un mandrin qui s'adapte à une forme de la cavité (112).

8. Procédé selon la revendication 1, dans lequel les surfaces supérieures des plots métalliques (123, 124) sont positionnées dans une partie centrale de la surface inférieure de la cavité (112).

9. Procédé selon la revendication 1, dans lequel le pochoir d'électroformage en 3D (310) est formé au moins en partie de nickel.
